(19) Europäisches Patentamt
European Patent Office
Office européen des brevets

(11) **EP 2 746 852 B1**

(12) **FASCICULE DE BREVET EUROPEEN**

(45) Date de publication et mention
de la délivrance du brevet:
**18.04.2018 Bulletin 2018/16**

(51) Int Cl.:
*G03F 7/20* (2006.01)     *G03F 1/00* (2012.01)
*G03F 1/36* (2012.01)     *G06F 17/50* (2006.01)
*H01J 37/317* (2006.01)     *G03F 1/82* (2012.01)

(21) Numéro de dépôt: **13196173.2**

(22) Date de dépôt: **09.12.2013**

(54) **Procédé d'estimation de motifs à imprimer sur plaque ou sur masque par lithographie à faisceau d'électrons et dispositif d'impression correspondant**

Verfahren zur Bewertung von Druckmotiven auf einer Platte oder einer Maske durch Elektronenstrahllithografie, und entsprechende Druckvorrichtung

Method for estimating patterns to be printed on a plate or mask by means of electron-beam lithography and corresponding printing device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2012 FR 1262521**

(43) Date de publication de la demande:
**25.06.2014 Bulletin 2014/26**

(73) Titulaires:
• **Commissariat à l'Énergie Atomique et aux Énergies Alternatives**
**75015 Paris (FR)**
• **Aselta Nanographics**
**38000 Grenoble (FR)**

(72) Inventeur: **Belledent, Jérôme**
**38240 Meylan (FR)**

(74) Mandataire: **Bonnet, Michel**
**Cabinet Bonnet**
**93, rue Réaumur - Boîte 10**
**75002 Paris (FR)**

(56) Documents cités:
**DE-A1- 19 840 833     DE-A1-102010 035 047**

• **KEIL K ET AL: "Fast backscattering parameter determination in e-beam lithography with a modified doughnut test", MICROELECTRONIC ENGINEERING, ELSEVIER PUBLISHERS BV., AMSTERDAM, NL, vol. 86, no. 12, 1 décembre 2009 (2009-12-01), pages 2408-2411, XP026696797, ISSN: 0167-9317, DOI: 10.1016/J.MEE.2009.05.002 [extrait le 2009-05-10]**
• **STEVENS L ET AL: "Determination of the proximity parameters in electron beam lithography using DOUGHNUT-structures", MICROELECTRONIC ENGINEERING NETHERLANDS, vol. 5, no. 1-4, décembre 1986 (1986-12), pages 141-150, XP002713436, ISSN: 0167-9317**

**Description**

La présente invention concerne un procédé d'estimation de motifs à imprimer sur plaque ou sur masque par lithographie à faisceau d'électrons. Elle concerne également un dispositif d'impression mettant en oeuvre ce procédé.

L'invention s'applique plus particulièrement à un procédé de ce type comportant les étapes suivantes :

- impression par lithographie à faisceau d'électrons, dans une résine disposée sur un substrat, d'un ensemble de motifs de calibrage,
- mesure de dimensions caractéristiques de l'ensemble de motifs de calibrage après impression et enregistrement de ces dimensions caractéristiques en mémoire,
- fourniture, par un processeur ayant accès à la mémoire, d'une estimation de la fonction d'étalement du point caractérisant des électrons diffusés lors de l'impression à partir des dimensions caractéristiques mesurées,
- estimation des motifs à imprimer par convolution de la fonction d'étalement du point fournie avec une valeur initiale de ces motifs à imprimer. Un tel procédé est connu par exemple de DE102010035047 A1. La lithographie par faisceau d'électrons ne peut pas s'affranchir d'une phase de préparation d'un motif à imprimer compte tenu des effets de proximité engendrés par la diffusion des électrons, d'autres espèces chimiques dans la résine, ou autres effets susceptibles de déformer le motif à imprimer et qu'il est nécessaire de compenser. Notamment, l'exposition du substrat au faisceau d'électrons engendre des électrons diffusés, incluant des électrons diffusés dans la résine et des électrons rétrodiffusés par le substrat, produisant ce que l'on appelle « l'effet de proximité ». Cet effet provoque un élargissement du motif final imprimé sur la résine par rapport au motif initialement souhaité. L'effet est d'autant plus gênant que les motifs à placer sont fins et se trouvent dans une zone où la densité de motifs à imprimer est grande.

D'une façon générale, pour pouvoir compenser cet effet, une méthode connue consiste à modéliser la fonction d'étalement du point, encore appelée réponse percussionnelle, dite PSF (de l'anglais « Point Spread Function »), comportant la PSF des électrons rétrodiffusés par le substrat, dite $PSF_{BE}$ (de l'anglais « Backward scattered Electrons Point Spread Function ») et la PSF des électrons diffusés dans la résine, aussi connue de l'homme du métier comme la « PSF des électrons diffusés vers l'avant » et dite $PSF_{FE}$ (de l'anglais « Forward scattered Electrons Point Spread Function »). Cette fonction $PSF = PSF_{BE} + PSF_{FE}$ permet ensuite de calculer, lors d'une étape de simulation dite d'estimation, la dose finale à appliquer localement sur la résine pour l'impression du motif. Cette dose finale est estimée moyennant la convolution de la fonction PSF obtenue avec une valeur initiale du motif à imprimer. La dose ainsi obtenue tient compte de la dose parasite induite par l'effet de proximité sur le motif.

Une première solution consiste plus précisément à modéliser la forme de la PSF par une somme de fonctions de type gaussienne. Afin de déterminer les coefficients caractérisant ces fonctions gaussiennes, différents motifs de calibrage, par exemple des lignes, sont imprimés sur la résine en appliquant différentes doses de charges électriques au faisceau d'électrons. Des mesures de dimensions caractéristiques sont effectuées sur les motifs de calibrage imprimés et utilisées pour déterminer les paramètres de la fonction gaussienne par simulation à l'aide d'un programme informatique dédié et bien connu de l'homme du métier sous le nom de « solver ».

Néanmoins, les doses ainsi calculées sont imprécises et empêchent d'imprimer le motif avec une précision satisfaisante puisqu'en réalité la forme de la $PSF_{BE}$, n'est pas vraiment gaussienne. En effet, elle dépend de la distribution du nombre d'électrons rétrodiffusés et de la distribution de leur énergie qui ne suivent pas une loi gaussienne.

Il peut ainsi être souhaité de prévoir un procédé d'estimation de motifs à imprimer du type précité qui permette de s'affranchir d'au moins une partie des problèmes et contraintes précités, notamment qui permette de ne pas imposer de forme particulière à la $PSF_{BE}$ des électrons rétrodiffusés lors de l'impression et de s'affranchir de l'utilisation d'un « solver » pour le calcul de cette $PSF_{BE}$.

Il est donc proposé un procédé d'estimation de motifs à imprimer sur plaque ou sur masque par lithographie à faisceau d'électrons, comportant les étapes suivantes :

- impression par lithographie à faisceau d'électrons, dans une résine disposée sur un substrat, d'un ensemble de motifs de calibrage,
- mesure de dimensions caractéristiques de l'ensemble de motifs de calibrage après impression et enregistrement de ces dimensions caractéristiques en mémoire,
- fourniture, par un processeur ayant accès à la mémoire, d'une estimation de la fonction d'étalement du point caractérisant des électrons diffusés lors de l'impression à partir des dimensions caractéristiques mesurées,
- estimation des motifs à imprimer par convolution de la fonction d'étalement du point fournie avec une valeur initiale de ces motifs à imprimer,

dans lequel :

- chaque motif de calibrage imprimé dans la résine comporte une zone centrale exposée au faisceau d'électrons et une pluralité de zones concentriques à symétrie de révolution disposées autour de cette zone centrale,
- les dimensions caractéristiques mesurées après impression sont des dimensions caractéristiques des zones centrales des motifs, et
- l'estimation de la fonction d'étalement du point est calculée en tant que somme d'une première portion de fonction d'étalement du point caractérisant des électrons rétrodiffusés par le substrat et d'une seconde portion de fonction d'étalement du point caractérisant des électrons diffusés dans la résine, et comporte une inversion d'une modélisation analytique de l'effet, sur lesdites dimensions caractéristiques, de l'application de la première portion de fonction d'étalement du point à l'ensemble de motifs de calibrage.

Grâce à l'invention, le calcul de la PSF des électrons diffusés dans la résine et rétrodiffusés par le substrat ne fait pas d'hypothèse sur la forme de la portion $PSF_{BE}$ (si ce n'est sa symétrie de révolution) et les doses ainsi calculées lors de l'étape d'estimation des motifs à imprimer sont suffisamment précises pour parvenir à imprimer les motifs souhaités avec une précision améliorée et en ayant compensé les effets de proximité. Outre la précision du résultat, le calcul de la $PSF_{BE}$ est aussi accéléré, car il résulte directement des mesures des dimensions caractéristiques des motifs de calibrage de sorte qu'aucun programme de simulation numérique (« solver ») n'est nécessaire.

De façon optionnelle, l'application de la première portion de fonction d'étalement du point à l'ensemble de motifs de calibrage est modélisée analytiquement par le produit d'une matrice modélisant l'ensemble de motifs de calibrage avec un vecteur modélisant la première portion de fonction d'étalement du point, l'inversion de la modélisation analytique étant réalisée par une inversion de la matrice modélisant l'ensemble de motifs de calibrage.

De façon optionnelle également, la matrice modélisant l'ensemble de motifs de calibrage est une matrice carrée d'ordre n modélisant un ensemble de n motifs à n zones concentriques, chaque ligne de la matrice correspondant à l'un des motifs de calibrage et chaque colonne de la matrice correspondant à l'une de ces zones concentriques.

De façon optionnelle également, la matrice modélisant l'ensemble de motifs de calibrage est exprimée à partir d'une matrice de Hadamard.

De façon optionnelle également, la première portion de fonction d'étalement du point caractérisant les électrons rétrodiffusés par le substrat, notée $PSF_{BE}$, est définie par l'expression suivante :

$$PSF_{BE} \propto \left( \frac{2}{n} H - \begin{bmatrix} 1 & 0 & \cdots & 0 \\ 0 & 0 & \cdots & 0 \\ \vdots & \vdots & & \vdots \\ 0 & 0 & \cdots & 0 \end{bmatrix} \right) \left( \begin{bmatrix} \frac{CD[1]}{S[1]} \\ \vdots \\ \frac{CD[n]}{S[n]} \end{bmatrix} - cd_0 \begin{bmatrix} 1 \\ \vdots \\ 1 \end{bmatrix} \right),$$

où le symbole « $\propto$ » désigne une relation de proportionnalité, $H$ est la matrice de Hadamard à partir de laquelle l'ensemble de motifs de calibrage est modélisé, $\begin{bmatrix} \frac{CD[1]}{S[1]} \\ \vdots \\ \frac{CD[n]}{S[n]} \end{bmatrix}$ est un vecteur comportant l'ensemble $\{CD[1],...,CD[n]\}$ des dimensions caractéristiques mesurées, pondéré par l'ensemble $\{S[1],...S[n]\}$ des surfaces respectives des zones concentriques à symétrie de révolution, et $cd_0$ est une constante caractéristique d'une dimension commune de la zone centrale de chaque motif de calibrage lorsque cette zone centrale est exposée de manière isolée au faisceau d'électrons en l'absence de zones concentriques à symétrie de révolution autour de cette zone centrale.

De façon optionnelle également, la seconde portion de fonction d'étalement du point est modélisée à partir d'une fonction de type gaussienne, les paramètres de cette fonction gaussienne étant déterminés par simulation sur une pluralité de motifs de calibrage.

De façon optionnelle également, les zones concentriques à symétrie de révolution des motifs de calibrage sont toutes de même surface.

De façon optionnelle également, la première portion de fonction d'étalement du point caractérisant les électrons rétrodiffusés par le substrat est définie par l'expression suivante :

$$PSF_{BE} \propto \left( \frac{2}{n} H - \begin{bmatrix} 1 & 0 & \cdots & 0 \\ 0 & 0 & \cdots & 0 \\ \vdots & \vdots & & \vdots \\ 0 & 0 & \cdots & 0 \end{bmatrix} \right) \left( \begin{bmatrix} CD[1] \\ \vdots \\ CD[n] \end{bmatrix} - cd_0 \begin{bmatrix} 1 \\ \vdots \\ 1 \end{bmatrix} \right).$$

De façon optionnelle également, la zone centrale de chaque motif de calibrage comporte l'une des zones concentriques à symétrie de révolution, celle-ci étant alors placée au centre dudit motif.

Il est également proposé un dispositif d'impression de motifs sur plaque ou sur masque par lithographie à faisceau d'électrons, comportant :

- des moyens d'impression par lithographie à faisceau d'électrons, dans une résine disposée sur un substrat, d'un ensemble de motifs de calibrage,
- des moyens de mesure de dimensions caractéristiques de l'ensemble de motifs de calibrage après impression et des moyens de stockage de ces dimensions caractéristiques en mémoire,
- un processeur ayant accès à la mémoire et programmé pour fournir une estimation de la fonction d'étalement du point caractérisant des électrons diffusés lors de l'impression à partir des dimensions caractéristiques mesurées,
- des moyens d'estimation des motifs à imprimer par convolution de la fonction d'étalement du point fournie avec une valeur initiale de ces motifs à imprimer,

dans lequel, chaque motif de calibrage destiné à être imprimé dans la résine comportant une zone centrale exposée au faisceau d'électrons et une pluralité de zones concentriques à symétrie de révolution disposées autour de cette zone centrale :

- les moyens de mesure sont des moyens de mesure des dimensions caractéristiques des zones centrales des motifs après impression, et
- le processeur est programmé pour calculer l'estimation de la fonction d'étalement du point en tant que somme d'une première portion de fonction d'étalement du point caractérisant des électrons rétrodiffusés par le substrat et d'une seconde portion de fonction d'étalement du point caractérisant des électrons diffusés dans la résine, et par inversion d'une modélisation analytique de l'effet, sur lesdites dimensions caractéristiques, de l'application de la première portion de fonction d'étalement du point à l'ensemble de motifs de calibrage.

L'invention sera mieux comprise à l'aide de la description qui va suivre, donnée uniquement à titre d'exemple et faite en se référant aux dessins annexés dans lesquels :

- la figure 1 représente schématiquement la structure générale d'un dispositif d'impression, selon un mode de réalisation de l'invention,
- La figure 2 illustre un ensemble de motifs de calibrage utilisé pour estimer la fonction d'étalement du point caractérisant des électrons diffusés lors de l'impression d'un motif par le dispositif d'impression de la figure 1, et
- la figure 3 illustre les étapes successives d'un procédé d'estimation mis en oeuvre par le dispositif d'impression de la figure 1 à l'aide de l'ensemble de motifs de la figure 2.

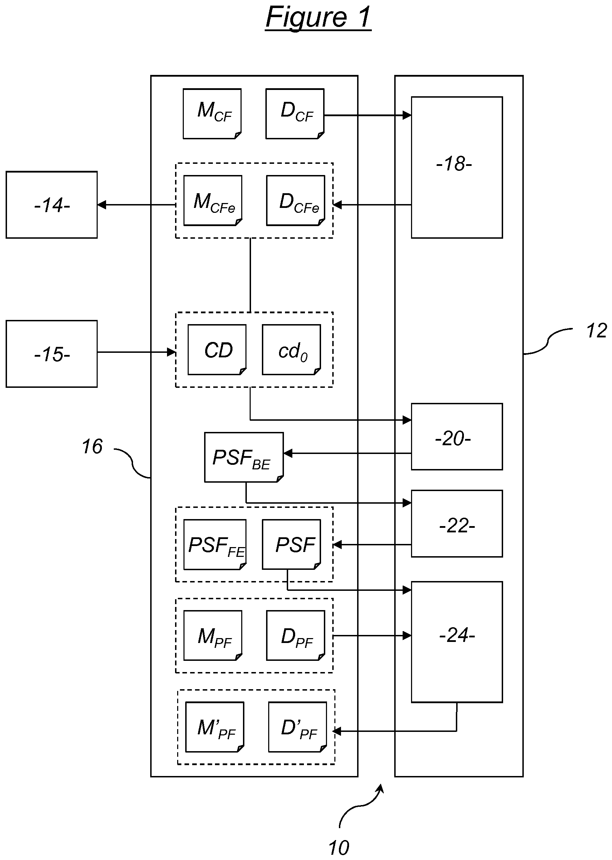

Le dispositif d'impression 10 représenté schématiquement sur la figure 1 comporte un module de traitement 12, un module 14 d'impression de motifs sur plaque ou sur masque par lithographie à faisceau d'électrons et un module 15 de mesure de dimensions caractéristiques de motifs imprimés par le module 14, tous les trois associés de façon classique à une mémoire 16 (par exemple une mémoire RAM). Le module de traitement 12 peut par exemple être mis en oeuvre dans un dispositif informatique tel qu'un ordinateur classique comportant un processeur associé à une ou plusieurs mémoires pour le stockage de fichiers de données et de programmes d'ordinateur. Le module de traitement 12 peut alors lui-même être considéré comme formé d'un processeur associé à une mémoire de stockage des instructions qu'il exécute sous forme de programmes d'ordinateur.

Le module de traitement 12 tel qu'illustré sur la figure 1 comporte ainsi fonctionnellement quatre programmes d'ordinateur 18, 20, 22 et 24.

Le premier programme d'ordinateur 18 est un programme de préparation préalable d'un ensemble de motifs de calibrage $M_C$ à imprimer par lithographie à faisceau d'électrons dont les paramètres sont stockés en mémoire 16. L'ensemble de motifs de calibrage $M_C$ est par exemple plus précisément modélisé par un ensemble de formes géométriques $M_{CF}$ affectées à un ensemble de doses prédéterminées $D_{CF}$. Par « dose », on entend une dose de charges électriques à appliquer au faisceau d'électrons lors de l'impression individuelle de la forme géométrique qui lui est associée.

A partir de l'ensemble $M_{CF}$ de formes géométriques et de l'ensemble $D_{CF}$ de doses prédéterminées enregistrées en mémoire 16, ces paramètres définissant théoriquement l'ensemble de motifs de calibrage $M_C$ à imprimer, le premier programme 18 est conçu pour fournir un ensemble de formes géométriques élémentaires $M_{CFe}$ modélisant les motifs de calibrage $M_C$ et un ensemble associé de doses $D_{CFe}$ choisies parmi un ensemble de valeurs discrètes, par exemple des valeurs discrètes de l'ensemble $D_{CF}$ si celui-ci est lui-même à valeurs discrètes. Ces ensembles $M_{CFe}$ et $D_{CFe}$ sont par exemple stockés en mémoire 16.

Une première solution bien connue consiste plus précisément à modéliser l'ensemble de motifs de calibrage $M_C$ par un ensemble de formes géométriques élémentaires $M_{CFe}$ juxtaposées et à affecter à chaque forme élémentaire une dose et un temps d'exposition indépendants des autres. Mais comme en pratique les doses doivent être choisies dans un ensemble $D_{CF}$ discret et limité de doses prédéterminées, il est alors souvent nécessaire de multiplier les formes géométriques élémentaires et de prévoir certaines formes de très petites tailles pour compenser la discrétisation des doses et obtenir une bonne précision d'impression.

Une autre solution est par exemple décrite dans l'article de C. Pierrat et al, intitulé « Mask data correction methodology in the context of model-base fracturing and advanced mask models », publié dans Proceedings SPIE of Optical Microlithography n° 24, vol. 7973, 1-3 mars 2011, San Jose (CA), US. Cette solution autorise la superposition des formes géométriques élémentaires de sorte que l'on peut ainsi très sensiblement réduire leur nombre et limiter les formes géométriques de petites tailles. Mais la superposition des formes rend les autres paramètres, notamment les doses de charges électriques et les temps d'exposition, dépendants les uns des autres.

Une troisième solution plus performante et originale consiste à définir les formes géométriques élémentaires $M_{CFe}$ sous la forme de pixels identiques juxtaposés en matrice, formant ainsi un pavage bidimensionnel régulier recouvrant l'ensemble de motifs de calibrage $M_C$, une correction d'erreur de discrétisation pouvant alors être réalisée par tramage sur ces pixels lors de la détermination des doses $D_{CFe}$ à appliquer aux formes géométriques élémentaires.

Le module d'impression 14 tel qu'illustré sur la figure 1 permet d'imprimer par exposition au faisceau d'électrons d'une résine disposée sur un substrat, l'ensemble de motifs de calibrage $M_C$ à partir de l'ensemble $M_{CFe}$ de formes géométriques élémentaires et de l'ensemble $D_{CFe}$ associé de doses.

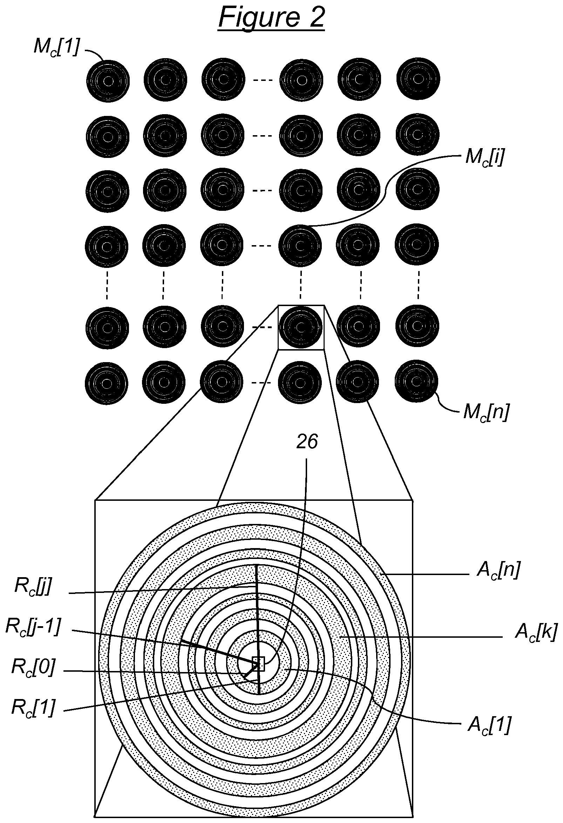

Le module de mesure 15 tel qu'illustré sur la figure 1 permet alors de mesurer des dimensions caractéristiques $CD$ de l'ensemble de motifs de calibrage $M_C$ après impression par le module 14. Comme cela sera détaillé ultérieurement en référence à la figure 2, chaque motif de calibrage imprimé dans la résine comporte une zone centrale exposée au faisceau d'électrons et une pluralité de zones concentriques à symétrie de révolution disposées autour de cette zone centrale. Les dimensions caractéristiques $CD$ mesurées après impression correspondent alors aux dimensions des zones centrales des motifs. A titre d'exemple, lorsque la zone centrale d'un motif est un disque, la dimension caractéristique de ce motif est la dimension du diamètre de ce disque. Les dimensions caractéristiques $CD$ de l'ensemble de motifs de calibrage $M_C$ sont par exemple enregistrées en mémoire 16.

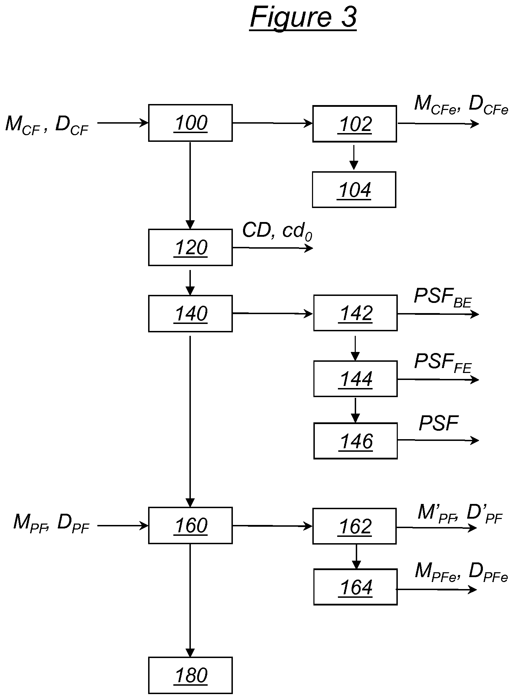

Le deuxième programme d'ordinateur 20 du module de traitement 12 est un calculateur de la fonction d'étalement du point caractérisant des électrons rétrodiffusés $PSF_{BE}$ dont le fonctionnement sera détaillé en référence à la figure 3. A partir des dimensions caractéristiques $CD$ mesurées et enregistrées en mémoire, ce programme d'ordinateur 20 fournit une estimation de la fonction d'étalement du point $PSF_{BE}$ caractérisant les électrons rétrodiffusés par le substrat lors de l'impression.

Cette estimation de la fonction $PSF_{BE}$ est calculée à partir d'une modélisation analytique de l'effet, sur les dimensions caractéristiques $CD$ de l'application de la fonction $PSF_{BE}$ à l'ensemble de motifs de calibrage $M_C$.

Plus précisément, l'effet, sur les dimensions caractéristiques $CD$, de l'application de la fonction $PSF_{BE}$ à l'ensemble de motifs de calibrage $M_C$ est modélisé analytiquement par le produit d'une matrice M modélisant l'ensemble de motifs de calibrage $M_C$ et d'un vecteur modélisant la fonction $PSF_{BE}$. A titre d'exemple, la $i^{ème}$ composante de ce vecteur correspond à la quantité d'électrons rétrodiffusés par la $i^{ème}$ zone concentrique. Par extension, ce vecteur sera également noté $PSF_{BE}$, et l'effet précité est défini selon l'expression suivante :

$$CD - cd_0 \propto M * \mathrm{PSF}_{BE},$$

où le symbole « $\propto$ » désigne une relation de proportionnalité et $cd_0$ est une constante caractéristique d'une dimension commune de la zone centrale de chaque motif de calibrage lorsque cette zone centrale est exposée de manière isolée au faisceau d'électrons en l'absence de zones concentriques à symétrie de révolution autour de cette zone centrale. Cette constante $cd_0$ peut être préétablie et stockée en mémoire 16.

On peut donc constater que l'effet de la fonction $PSF_{BE}$ sur l'ensemble de motifs de calibrage $M_C$ est proportionnel à l'élargissement des dimensions caractéristiques $CD$ des zones centrales du motif imprimé, cet élargissement étant provoqué par l'effet de proximité dû à la présence des zones concentriques imprimées autour.

L'inversion de cette modélisation analytique, réalisée par inversion de la matrice M modélisant l'ensemble de motifs de calibrage $M_C$, permet ainsi d'obtenir une estimation de la fonction $PSF_{BE}$ selon l'expression suivante :

$$\mathrm{PSF}_{BE} \propto M^{-1} * (CD - cd_0).$$

On note que cette inversion impose que la matrice M modélisant l'ensemble de motifs de calibrage soit une matrice carrée et inversible, ce qui impose également quelques contraintes à cet ensemble de motifs de calibrage $M_C$.

La fonction $PSF_{BE}$ ainsi obtenue est par exemple stockée en mémoire 16.

Le troisième programme d'ordinateur 22 du module de traitement 12 est un programme d'estimation de la fonction d'étalement du point PSF caractérisant des électrons diffusés lors de l'impression. Cette fonction est estimée en tant que somme de la première portion précitée de fonction d'étalement du point $PSF_{BE}$ caractérisant les électrons rétrodiffusés par le substrat et d'une seconde portion de fonction d'étalement du point $PSF_{FE}$ caractérisant des électrons diffusés dans la résine. Contrairement à la fonction $PSF_{BE}$, le comportement de la fonction $PSF_{FE}$ peut être modélisé par une fonction de type gaussienne. De ce fait, la seconde portion $PSF_{FE}$ peut être considérée comme une fonction gaussienne, les paramètres de cette fonction gaussienne étant déterminés par simulation sur une pluralité de motifs de calibrage et à l'aide d'un logiciel dédié. Cette méthode bien connue de l'homme du métier permet ainsi d'obtenir une estimation de la fonction $PSF_{FE}$ suffisamment précise. Les fonctions ainsi calculées, $PSF_{FE}$ et $PSF = PSF_{BE} + PSF_{FE}$, sont par exemple stockées en mémoire 16.

Le quatrième programme d'ordinateur 24 du module de traitement 12 est un programme d'estimation de motifs à imprimer par le dispositif d'impression 10, par convolution de la fonction d'étalement du point PSF, fournie par le programme d'ordinateur 22, avec une valeur initiale de ces motifs à imprimer. Un motif à imprimer comporte par exemple un ensemble de formes géométriques à imprimer, de valeur initiale $M_{PF}$, associé à un ensemble de doses prédéfinies, de valeur initiale $D_{PF}$, à appliquer au faisceau d'électrons lors de l'impression dudit motif. Le résultat de cette convolution donne une valeur finale $(M'_{PF},D'_{PF})$ du motif à imprimer sur lequel les effets des doses parasites induites par l'effet de proximité ont été compensés.

Le motif à imprimer $(M'_{PF},D'_{PF})$ ainsi calculé est ensuite utilisé lors de la modélisation du motif en formes géométriques élémentaires $M_{PFe}$ à partir de l'ensemble de formes géométriques à imprimer $M'_{PF}$ et plus précisément lors du calcul, par un programme similaire au programme de préparation préalable 18 ou par ce programme lui-même, de l'ensemble de doses $D_{PFe}$ associées audites formes géométriques élémentaires $M_{PFe}$. Enfin, l'impression sur la résine du motif $(M'_{PF},D'_{PF})$ est effectuée par le module d'impression 14 à partir de l'ensemble $M_{PFe}$ de formes géométriques élémentaires et de l'ensemble associé de doses $D_{PFe}$ avec une précision améliorée et en ayant compensé les effets de proximité.

On notera par ailleurs que les programmes d'ordinateur 18, 20, 22 et 24 sont présentés comme distincts, mais cette distinction est purement fonctionnelle. Ils pourraient tout aussi bien être regroupés en un ou plusieurs logiciels. Leurs fonctions pourraient aussi être au moins en partie micro programmées ou micro câblées dans des circuits intégrés dédiés. Ainsi, en variante, le dispositif informatique mettant en oeuvre le module de traitement 12 pourrait être remplacé par un dispositif électronique composé uniquement de circuits numériques (sans programme d'ordinateur) pour la réalisation des mêmes actions.

La figure 2 illustre à titre d'exemple un ensemble de motifs de calibrage $M_C$ compatible avec une modélisation matricielle inversible selon l'invention. Chaque motif de calibrage $M_C[i]$ de l'ensemble de n motifs de calibrage $M_C = \{M_C[i], 0 < i \leq n\}$ à imprimer dans la résine comporte une zone centrale 26 exposée au faisceau d'électrons et un ensemble $A_C$ de n zones concentriques $A_C = \{A_C[k], 0 < k \leq n\}$ à symétrie de révolution, disposées autour de cette zone centrale 26. Dans cet exemple de réalisation, les zones concentriques $A_C$ à symétrie de révolution sont ordonnées par ordre de rayons croissants $R_C = \{R_C[j], 0 \leq j \leq n\}$ et sont toutes de même surface S.

Cet ensemble de motifs de calibrage $M_C$ peut être modélisé par une matrice carrée M exprimée à partir d'une matrice de Hadamard, H, d'ordre n. Chaque ligne de la matrice de Hadamard H correspond à l'un des n motifs de calibrage $M_C[i]$, chaque motif de calibrage comportant n zones concentriques $A_C$. Chaque colonne de la matrice de Hadamard H représente l'exposition au faisceau d'électrons d'une de ces zones concentriques $A_C[k]$ pour tous les motifs de calibrage $M_C[1],...,M_C[n]$. Ainsi la première colonne de la matrice H correspond aux zones concentriques $A_C[1]$ les plus proches de chaque zone centrale 26 des motifs de calibrage $M_C$ et la dernière colonne de la matrice H correspond aux zones concentriques $A_C[n]$ les plus éloignées de chaque zone centrale 26 des motifs de calibrage $M_C$. L'exposition du $i^{ème}$ motif de calibrage $M_C[i]$ au faisceau d'électrons est ainsi représentée par la $i^{ème}$ ligne de la matrice H. L'ensemble de valeurs des coefficients de la matrice de Hadamard H étant limité à deux valeurs discrètes, 1 ou -1, seules les zones concentriques $A_C$ à symétrie de révolution correspondant aux coefficients de valeur 1 de la matrice de Hadamard H sont exposées au faisceau d'électrons.

On remarquera que le fait qu'une matrice carrée soit utilisée comme matrice M modélisant l'ensemble de motifs de calibrage $M_C$ implique que le nombre total n de zones concentriques $A_C$ à symétrie de révolution dans l'un quelconque des motifs de calibrage $M_C[i]$ est strictement égal au nombre total n de motifs de calibrage $M_C[1],...,M_C[n]$ imprimés dans la résine.

En outre, le fait que la matrice de Hadamard H soit utilisée pour exprimer la matrice M modélisant l'ensemble $M_C$ de motifs de calibrage garantit que la moitié n/2 des zones concentriques $A_C$ à symétrie de révolution appartenant à chacun des motifs $M_C[i]$ soit exposée au faisceau d'électrons, ceci étant valable pour tous les motifs de calibrage imprimés dans la résine sauf pour le premier motif $M_C[1]$. En effet, les valeurs des coefficients de la première ligne de la matrice de Hadamard H étant toutes égales à 1, toutes les zones concentriques $A_C$ à symétrie de révolution de ce motif de calibrage $M_C[1]$ sont en conséquence exposées au faisceau.

Le procédé d'estimation illustré sur la figure 3 et mis en oeuvre par le dispositif d'impression 10 de la figure 1 comporte une première étape 100 d'impression par lithographie à faisceau d'électrons d'un ensemble de motifs de calibrage $M_C$ dans une résine disposée sur un substrat.

Lors d'une première sous étape 102 de la première étape 100, le programme 18 de préparation préalable d'un ensemble de motifs de calibrage $M_C$ à imprimer, après avoir extrait préalablement de la mémoire les ensembles $M_{CF}$ de formes géométriques et $D_{CF}$ de doses prédéterminées, fournit l'ensemble de formes géométriques élémentaires $M_{CFe}$ et l'ensemble de doses $D_{CFe}$ associées. Ces ensembles $M_{CFe}$ et $D_{CFe}$ sont stockés en mémoire 16.

Au cours d'une deuxième sous étape 104 de la première étape 100, le dispositif 14 d'impression par lithographie à faisceau d'électrons imprime l'ensemble de motifs de calibrage $M_C$ par exposition d'une résine disposée sur un substrat à partir desdits ensembles $M_{CFe}$ et $D_{CFe}$ préalablement extraits de la mémoire 16 par ce dispositif 14.

Au cours d'une deuxième étape 120, le module de mesure 15 fournit les dimensions caractéristiques $CD$ des zones centrales 26 de chaque motif de calibrage $M_C[i]$ imprimé. Ce module peut également participer à la fourniture de la valeur $cd_0$ correspondant à une constante caractéristique d'une dimension commune de la zone centrale 26 de chaque motif de calibrage $M_C[i]$ lorsque cette zone centrale 26 est exposée de manière isolée au faisceau d'électrons en l'absence de zones concentriques $A_C$ à symétrie de révolution autour de cette zone centrale 26.

La constante $cd_0$ peut en effet être obtenue expérimentalement, par exemple en fixant la dose d'exposition de la zone centrale 26 d'un motif de calibrage $M_C[i]$ quelconque et en faisant décroître progressivement la dose d'exposition $D_{CF}$ des zones concentriques $A_C$ à symétrie de révolution de ce motif. Ensuite, une solution possible consiste à tracer une courbe à partir de l'acquisition de la dimension caractéristique $CD[i]$ de la zone centrale du motif de calibrage $M_C[i]$ considéré pour chaque dose différente appliquée aux zones concentriques $A_C$ autour. Enfin, la dimension théorique $cd_0$ correspondant à une dose d'exposition des zones concentriques $A_C$ égale à zéro peut être déterminée par extrapolation de ladite courbe, en tenant compte de la continuité en zéro de la fonction PSF et de sa fonction dérivée.

Au cours d'une troisième étape 140, les programmes d'ordinateur 20 et 22 du module de traitement 12 permettent d'estimer la fonction PSF d'étalement du point caractérisant les électrons diffusés lors de l'impression à partir des dimensions caractéristiques $CD$ mesurées et de la constante $cd_0$.

Lors d'une première sous-étape 142 de la troisième étape 140, le programme d'ordinateur 20, après extraction de la mémoire 16 de l'ensemble des dimensions $CD = \{CD[i], 0 < i \le n\}$ de la zone centrale 26 de chacun des n motifs de calibrage $M_C = \{M_C[i], 0 < i \le n\}$ ainsi que de la constante $cd_0$, fournit une estimation de la fonction d'étalement du point $PSF_{BE}$ permettant de caractériser les électrons rétrodiffusés par le substrat.

Une estimation de la $PSF_{BE}$ fournissant de bons résultats est calculée à titre d'exemple ci-dessous.

Pour rappel, la fonction d'étalement du point PSF des électrons diffusés est estimée par la relation $PSF = PSF_{FE} + PSF_{BE}$ où $PSF_{BE}$ est une première portion de fonction d'étalement du point caractérisant les électrons rétrodiffusés par le substrat et $PSF_{FE}$ une seconde portion de fonction d'étalement du point caractérisant les électrons diffusés dans la résine.

De façon générale, la dose D induite par les motifs de calibrage exposés en tout point P de la surface à imprimer résulte de la convolution de la matrice M modélisant l'ensemble de motifs de calibrage $M_C$ avec la PSF modélisant la totalité des électrons diffusés par le substrat. Ainsi, la dose D en tout point P est définie selon l'expression suivante :

$$D(P) = \iint_{P' \in \Re^2} \left( PSF_{FE}(\overrightarrow{PP'}) + PSF_{BE}(\overrightarrow{PP'}) \right) M(P') \, dxdy,$$

où la matrice M(P') représente les motifs de calibrage $M_C$ imprimés en tout point P' de la surface à imprimer, valant 1 pour tout P' exposé au faisceau d'électrons et 0 partout ailleurs.

Selon un mode de réalisation préféré et déjà mentionné précédemment, cette matrice M(P') est représentée à l'aide d'une matrice de Hadamard H dans laquelle les valeurs des coefficients de la matrice sont corrigées pour passer des valeurs 1 et -1 aux valeurs 1 et 0 respectivement.

En supposant que la distance d'un point P', appartenant à la surface du i^ème motif de calibrage $M_C[i]$, à tout point P situé au voisinage de la zone centrale 26 de ce motif de calibrage peut être approchée par la distance entre ce point P' et le centre de la zone centrale 26 du motif de calibrage $M_C[i]$, et en passant d'un système de coordonnées cartésiennes $(x,y)$ à un système de coordonnées polaires $(r, \theta)$, la dose au voisinage de la i^ème zone centrale $D_i(P)$ peut être approchée par l'expression suivante :

$$D_i(P) =$$

$$D_0(P) + \sum_{j=1}^{n} \int_0^{2\pi} \int_{R_{j-1}}^{R_j} \frac{h_{i,j}+1}{2} PSF_{FE}(r,\theta) r dr d\theta + \sum_{j=1}^{n} \int_0^{2\pi} \int_{R_{j-1}}^{R_j} \frac{h_{i,j}+1}{2} PSF_{BE}(r,\theta) r dr d\theta ,$$

où $D_0(P)$ correspond à la dose de la zone centrale 26 du i^ème motif de calibrage $M_C[i]$ lorsque cette zone centrale 26

est exposée de manière isolée au faisceau d'électrons en l'absence de zones concentriques $A_C$ à symétrie de révolution autour de cette zone centrale 26 et $h_{i,j}$ représente les coefficients de la matrice de Hadamard H et donc l'exposition de la j$^{ème}$ zone concentrique $A_C[j]$ du i$^{ème}$ motif de calibrage $M_C[i]$. On notera que c'est l'expression $\frac{h_{i,j}+1}{2}$ qui permet de passer de la valeur -1 d'un coefficient de la matrice de Hadamard H à la valeur 0 d'un coefficient de la matrice M.

On notera ainsi que dans l'exemple de réalisation ci-dessus la matrice M carrée modélisant l'ensemble de motifs de calibrage $M_C$ peut être exprimée à l'aide d'une matrice de Hadamard. Mais dans d'autres modes de réalisation de l'invention, une matrice différente pourrait être utilisée, cette matrice étant nécessairement cependant une matrice inversible.

La dose $D_i(P)$ au voisinage de la i$^{ème}$ zone centrale ainsi obtenue tient compte de la dose parasite induite par les zones concentriques $A_C$ appartenant au i$^{ème}$ motif et néglige l'influence du reste des motifs autour. Elle est donc valide seulement si les différents motifs de calibrage $M_C[i]$ sont suffisamment éloignés entre eux pour pouvoir négliger leurs influences croisées.

Afin de simplifier l'expression, $D_i(P)$ deux approximations sont ensuite utilisées :

- le support de la fonction PSF$_{FE}$ étant inférieur au rayon $R_C[0]$, de la zone concentrique $A_C[1]$ la plus proche de la zone centrale 26 d'un motif de calibrage $M_C[i]$, l'influence de la PSF$_{FE}$ des zones concentriques $A_C$ de ce motif $M_C[i]$ sur sa zone centrale 26 peut être négligée,
- la valeur de la fonction PSF$_{BE}$ est constante sur la surface d'une zone concentrique $A_C[j]$ et son amplitude dépend de la distance de ladite zone concentrique à la zone centrale 26, $PSF_{BE}(j)$. A titre d'exemple, $PSF_{BE}(j)$ pourrait être égale à la valeur moyenne de la PSF$_{BE}$ sur la zone concentrique $A_C[j]$.

En tenant compte des approximations précédentes, la dose au voisinage de la i$^{ème}$ zone centrale $D_i(P)$ peut être approchée par l'expression suivante :

$$D_i(P) \simeq D_0(P) + S \sum_{j=1}^{n} \frac{h_{i,j}+1}{2} \overline{PSF_{BE}}(j),$$

où S représente la surface d'une zone concentrique $A_C[j]$ sachant que toutes les zones concentriques sont de même surface.

La même expression peut être reprise sous forme matricielle :

$$D(P) \simeq D_0(P) + S \frac{H+1}{2} \overline{PSF_{BE}}.$$

La dose $D(P)$ au voisinage de la zone centrale est ainsi approchée par la somme de la dose $D_0(P)$ de la zone centrale 26 exposée isolément et d'une dose parasite constante modulée par la nature des zones concentriques $A_C$ exposées selon l'expression : $S \frac{H+1}{2} \overline{PSF_{BE}}.$ Un avantage, provenant du fait que la matrice M modélisant l'ensemble de motifs de calibrage $M_C$ puisse être exprimée à l'aide d'une matrice de Hadamard H d'ordre n, est que la valeur totale de ladite dose parasite varie peu d'un motif à l'autre puisque n/2 zones concentriques $A_C$ sont toujours exposées (à l'exception du premier motif).

En considérant que la taille des zones centrales $CD$ des motifs de calibrage varie de façon linéaire avec la dose parasite, on peut en déduire l'expression : $CD \propto cd_0 + S \frac{H+1}{2} \overline{PSF_{BE}},$ où le signe du facteur de proportionnalité dépend de la polarité de la résine utilisée.

Le facteur constant S de l'expression précédente est un coefficient de proportionnalité participant à l'effet de la fonction d'étalement du point PSF$_{BE}$ sur l'élargissement des dimensions caractéristiques $CD$ des zones centrales 26 selon l'expression suivante :

$$(CD - cd_0) \propto \left(\frac{H+1}{2}\right) \overline{PSF_{BE}}.$$

En multipliant cette expression par $\left(\frac{H+1}{2}\right)^{-1}$ de chaque côté et en appliquant les propriétés des matrices de Hadamard bien connues de l'homme du métier, on obtient l'expression suivante pour la fonction PSF$_{BE}$ :

$$\overline{PSF_{BE}} \propto \left(\tfrac{H+1}{2}\right)^{-1}(CD - cd_0) = \left(\tfrac{2}{n}H - \begin{bmatrix} 1 & 0 & \cdots & 0 \\ 0 & 0 & \cdots & 0 \\ \vdots & \vdots & \cdots & \vdots \\ 0 & 0 & \cdots & 0 \end{bmatrix}\right)\left(CD - cd_0\begin{bmatrix}1\\ \vdots \\ 1\end{bmatrix}\right)$$

où $CD = \begin{bmatrix} CD[1] \\ \vdots \\ CD[n] \end{bmatrix}$ est le vecteur comportant l'ensemble {$CD[1]$,...,$CD[n]$} des dimensions caractéristiques mesurées.

En conséquence, l'estimation de la fonction $\overline{PSF_{BE}}$ est calculée par inversion de la modélisation analytique de l'effet, sur les dimensions caractéristiques *CD*, de son application à l'ensemble de motifs de calibrage $M_C$.

On notera que du fait que la matrice de Hadamard H est utilisée comme matrice participant à la modélisation de l'ensemble de motifs de calibrage $M_C$, chaque valeur de la fonction $\overline{PSF_{BE}}$ ainsi obtenue est proportionnelle à une moyenne de n/2 mesures de dimensions caractéristiques *CD*, correspondant aux n/2 zones concentriques $A_C$ exposées au faisceau d'électrons. Ainsi, selon le théorème central limite, la fonction $\overline{PSF_{BE}}$ est une variable aléatoire qui tend à être normalement distribuée lorsque n augmente. L'écart type $\sigma_{PSFBE}$ de cette variable aléatoire $\overline{PSF_{BE}}$ est directement proportionnel à l'écart type $\sigma_{CD}$ de l'ensemble *CD* de dimensions caractéristiques des motifs de calibrage $M_C$ et inversement proportionnel à la racine du nombre de motifs : $\sigma_{PSF_{BE}} \propto \sigma_{CD}\sqrt{\tfrac{2}{n}}.$ Un nombre n suffisamment élevé de motifs de calibrage $M_C$ garantira donc la précision de la fonction $PSF_{BE}$ ainsi calculée. De plus, cette précision est améliorée par rapport à un autre mode de réalisation possible où l'influence de chaque zone concentrique serait mesurée séparément sans faire de moyenne.

Lors d'une deuxième sous-étape 144 de la troisième étape 140, le programme d'ordinateur 22, après extraction de la mémoire 16 de la fonction $PSF_{BE}$, fournit une estimation de la fonction d'étalement du point $PSF_{FE}$ caractérisant les électrons diffusés dans la résine, cette fonction $PSF_{FE}$ étant déterminée par simulation de façon connue en soi à partir d'un modèle gaussien.

Lors d'une troisième sous-étape 146 de la troisième étape 140, le programme d'ordinateur 22 fournit une estimation de la fonction d'étalement du point PSF caractérisant des électrons diffusés lors de l'impression en effectuant la somme de la fonction $PSF_{BE}$ et de la fonction $PSF_{FE}$.

Au cours d'une quatrième étape 160 le programme d'ordinateur 24 du module de traitement 12 réalise l'estimation d'un motif ($M'_{PF}$,$D'_{PF}$) à imprimer.

Lors d'une première sous-étape 162 de cette quatrième étape 160, après extraction de la mémoire 16 de valeurs initiales d'un motif à imprimer ($M_{PF}$,$D_{PF}$) et de la fonction d'étalement du point PSF, le programme d'ordinateur 24 fournit par un calcul de convolution une estimation du motif ($M'_{PF}$,$D'_{PF}$) à imprimer sur lequel les effets des doses parasites induites par l'effet de proximité ont été compensés.

Lors d'une deuxième sous-étape 164 de la quatrième étape 160, le programme d'ordinateur 18 (ou un autre programme similaire), après extraction de la mémoire 16 du motif à imprimer ($M'_{PF}$,$D'_{PF}$), fournit l'ensemble de formes géométriques élémentaires $M_{PFe}$ et l'ensemble de doses associées $D_{PFe}$ modélisant ce motif et tenant compte de la dose parasite induite.

Enfin, au cours d'une cinquième étape 180, le module d'impression 14 effectue l'impression sur la résine du motif ($M'_{PF}$,$D'_{PF}$) à partir de l'ensemble de formes géométriques élémentaires $M_{PFe}$ et de l'ensemble associé de doses $D_{PFe}$ en ayant compensé les effets de proximité et donc avec une précision d'impression améliorée.

Bien entendu, des variantes de réalisation pour estimer la fonction $PSF_{BE}$ peuvent être envisagées. Ainsi, la zone centrale 26 de chaque motif de calibrage $M_C[i]$ pourrait comporter la première zone concentrique $A_C[1]$ à symétrie de révolution, celle-ci étant alors placée au centre du motif de calibrage.

Dans ce cas et à titre d'exemple, les dimensions caractéristiques *CD* de la zone centrale 26 de chaque motif de calibrage pour cette variante de réalisation comporteraient la taille du plus petit rayon $R_C[0]$ de la zone concentrique $A_C[1]$ à symétrie de révolution placée au centre du motif de calibrage pourvu qu'elle soit écrite sur tous les motifs de calibrage. La constante caractéristique $cd_0$ correspondrait alors à la valeur de $R_C[1]$, commune à chaque motif de calibrage $M_C[i]$, lorsque la zone concentrique $A_C[1]$ est exposée de manière isolée au faisceau d'électrons en l'absence de zones concentriques $A_C = \{A_C[k], 1 < k \le n\}$ à symétrie de révolution autour d'elle.

En variante également, les zones concentriques $A_C = \{A_C[k], 0 < k \le n\}$ à symétrie de révolution des motifs de calibrage $M_C$ pourraient être toutes de surfaces différentes $S = \{S[k], 0 < k \le n\}$. Dans ce cas, lors du calcul de la fonction $PSF_{BE}$, la surface S ne peut plus être considérée comme un simple coefficient de proportionnalité entre la fonction PSF$_{BE}$ et les dimensions caractéristiques *CD* des zones centrales des motifs de calibrage. Plus précisément, dans l'expression de la fonction PSF$_{BE}$, l'ensemble {$CD[1],CD[2],...CD[n]$} des dimensions caractéristiques mesurées doit être pondéré par l'ensemble {$S[1],S[2],...S[n]$} des surfaces respectives des zones concentriques $A_C$ = {$A_C[k],0 < k \leq n$} à symétrie de révolution. La fonction PSF$_{BE}$ est, dans ce cas, définie par l'expression suivante :

$$PSF_{BE} \propto \left( \frac{2}{n}H - \begin{bmatrix} 1 & 0 & \cdots & 0 \\ 0 & 0 & \cdots & 0 \\ \vdots & \vdots & & \vdots \\ 0 & 0 & \cdots & 0 \end{bmatrix} \right) \left( \begin{bmatrix} \frac{CD[1]}{S[1]} \\ \vdots \\ \frac{CD[n]}{S[n]} \end{bmatrix} - cd_0 \begin{bmatrix} 1 \\ \vdots \\ 1 \end{bmatrix} \right).$$

Il apparaît clairement qu'un dispositif d'impression et qu'un procédé d'estimation de motifs à imprimer tel que ceux décrits précédemment permettent d'imprimer un motif sur plaque ou sur masque par lithographie à faisceau d'électrons avec une précision améliorée et une compensation satisfaisante des effets de proximité. En proposant un modèle d'estimation de la fonction PSF des électrons rétrodiffusés sans effectuer d'hypothèses sur la forme générale de la fonction PSF (si ce n'est sa symétrie de révolution), l'estimation des motifs à imprimer qui en résultent est suffisamment précise et les performances du dispositif d'impression sont améliorées.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

**Revendications**

1. Procédé d'estimation de motifs (*M'$_{PF}$*,*D'$_{PF}$*) à imprimer sur plaque ou sur masque par lithographie à faisceau d'électrons, comportant les étapes suivantes :

- impression (100) par lithographie à faisceau d'électrons, dans une résine disposée sur un substrat, d'un ensemble de motifs de calibrage (*M$_{CF}$*,*D$_{CF}$*),
- mesure (120) de dimensions caractéristiques (*CD*) de l'ensemble de motifs de calibrage (*M$_{CF}$*,*D$_{CF}$*) après impression et enregistrement de ces dimensions caractéristiques *(CD)* en mémoire,
- fourniture, par un processeur ayant accès à la mémoire (16), d'une estimation (140) de la fonction d'étalement du point (PSF) caractérisant des électrons diffusés lors de l'impression à partir des dimensions caractéristiques (*CD*) mesurées,
- estimation (160) des motifs (*M'$_{PF}$*,*D'$_{PF}$*) à imprimer par convolution de la fonction d'étalement du point (PSF) fournie avec une valeur initiale (*M$_{PF}$*,*D$_{PF}$*) de ces motifs à imprimer,

**caractérisé en ce que** :

- chaque motif de calibrage (*M$_C$[i]*) imprimé dans la résine comporte une zone centrale (26) exposée au faisceau d'électrons et une pluralité de zones concentriques à symétrie de révolution disposées autour de cette zone centrale (26),
- les dimensions caractéristiques *(CD)* mesurées après impression sont des dimensions caractéristiques (*CD*) des zones centrales 26 des motifs, et
- l'estimation de la fonction d'étalement du point (PSF) est calculée en tant que somme d'une première portion de fonction d'étalement du point (PSF$_{BE}$) caractérisant des électrons rétrodiffusés par le substrat et d'une seconde portion de fonction d'étalement du point (PSF$_{FE}$) caractérisant des électrons diffusés dans la résine, et comporte une inversion d'une modélisation analytique de l'effet, sur lesdites dimensions caractéristiques (*CD*), de l'application de la première portion de fonction d'étalement du point (PSF$_{BE}$) à l'ensemble de motifs de calibrage (*M$_{CF}$*,*D$_{CF}$*).

2. Procédé d'estimation de motifs (*M'$_{PF}$*,*D'$_{PF}$*) à imprimer selon la revendication 1, dans lequel l'application de la première portion de fonction d'étalement du point (PSF$_{BE}$) à l'ensemble de motifs de calibrage (*M$_{CF}$*,*D$_{CF}$*) est modélisée analytiquement par le produit d'une matrice modélisant l'ensemble de motifs de calibrage avec un vecteur modélisant la première portion de fonction d'étalement du point (PSF$_{BE}$), l'inversion de la modélisation analytique étant réalisée par une inversion de la matrice modélisant l'ensemble de motifs de calibrage.

3. Procédé d'estimation de motifs ($M'_{PF}$,$D'_{PF}$) à imprimer selon la revendication 2, dans lequel la matrice modélisant l'ensemble de motifs de calibrage ($M_{CF}$,$D_{CF}$) est une matrice carrée d'ordre n modélisant un ensemble de n motifs à n zones concentriques, chaque ligne de la matrice correspondant à l'un des motifs de calibrage ($M_C[i]$) et chaque colonne de la matrice correspondant à l'une de ces zones concentriques ($A_C[k]$).

4. Procédé d'estimation de motifs ($M'_{PF}$,$D'_{PF}$) à imprimer selon la revendication 3, dans lequel la matrice modélisant l'ensemble de motifs de calibrage ($M_{CF}$,$D_{CF}$) est exprimée à partir d'une matrice de Hadamard.

5. Procédé d'estimation de motifs ($M'_{PF}$,$D'_{PF}$) à imprimer selon la revendication 4, dans lequel la première portion de fonction d'étalement du point caractérisant les électrons rétrodiffusés par le substrat, notée $PSF_{BE}$, est définie par l'expression suivante :

$$PSF_{BE} \propto \left( \frac{2}{n}H - \begin{bmatrix} 1 & 0 & \cdots & 0 \\ 0 & 0 & \cdots & 0 \\ \vdots & \vdots & & \vdots \\ 0 & 0 & \dots & 0 \end{bmatrix} \right) \left( \begin{bmatrix} \frac{CD[1]}{S[1]} \\ \vdots \\ \frac{CD[n]}{S[n]} \end{bmatrix} - cd_0 \begin{bmatrix} 1 \\ \vdots \\ 1 \end{bmatrix} \right),$$

où le symbole « $\propto$ » désigne une relation de proportionnalité, $H$ est la matrice de Hadamard à partir de laquelle l'ensemble de motifs de calibrage ($M_{CF}$,$D_{CF}$) est modélisé, $\begin{bmatrix} \frac{CD[1]}{S[1]} \\ \vdots \\ \frac{CD[n]}{S[n]} \end{bmatrix}$ est un vecteur comportant l'ensemble

{$CD[1]$,...,$CD[n]$} des dimensions caractéristiques mesurées, pondéré par l'ensemble {$S[1]$,...$S[n]$} des surfaces respectives des zones concentriques à symétrie de révolution, et $cd_0$ est une constante caractéristique d'une dimension commune de la zone centrale (26) de chaque motif de calibrage ($M_C[i]$) lorsque cette zone centrale (26) est exposée de manière isolée au faisceau d'électrons en l'absence de zones concentriques à symétrie de révolution autour de cette zone centrale (26).

6. Procédé d'estimation de motifs ($M'_{PF}$,$D'_{PF}$) à imprimer selon l'une quelconque des revendications 1 à 5, dans lequel la seconde portion de fonction d'étalement du point (PSF$_{FE}$) est modélisée à partir d'une fonction de type gaussienne, les paramètres de cette fonction gaussienne étant déterminés par simulation sur une pluralité de motifs de calibrage.

7. Procédé d'estimation de motifs ($M'_{PF}$,$D'_{PF}$) à imprimer selon l'une quelconque des revendications 1 à 6, dans lequel les zones concentriques ($A_C[k]$) à symétrie de révolution des motifs de calibrage sont toutes de même surface.

8. Procédé d'estimation de motifs ($M'_{PF}$,$D'_{PF}$) à imprimer selon les revendications 5 et 7, dans lequel la première portion de fonction d'étalement du point (PSF$_{BE}$) caractérisant les électrons rétrodiffusés par le substrat est définie par l'expression suivante :

$$PSF_{BE} \propto \left( \frac{2}{n}H - \begin{bmatrix} 1 & 0 & \cdots & 0 \\ 0 & 0 & \cdots & 0 \\ \vdots & \vdots & & \vdots \\ 0 & 0 & \dots & 0 \end{bmatrix} \right) \left( \begin{bmatrix} CD[1] \\ \vdots \\ CD[n] \end{bmatrix} - cd_0 \begin{bmatrix} 1 \\ \vdots \\ 1 \end{bmatrix} \right).$$

9. Procédé d'estimation de motifs ($M'_{PF}$,$D'_{PF}$) à imprimer selon l'une quelconque des revendications 1 à 8, dans lequel la zone centrale (26) de chaque motif de calibrage ($M_C[i]$) comporte l'une des zones concentriques à symétrie de révolution, celle-ci étant alors placée au centre dudit motif.

10. Dispositif d'impression (10) de motifs ($M'_{PF}$,$D'_{PF}$) sur plaque ou sur masque par lithographie à faisceau d'électrons, comportant :

- des moyens d'impression (14) par lithographie à faisceau d'électrons, dans une résine disposée sur un substrat, d'un ensemble de motifs de calibrage ($M_{CF}$,$D_{CF}$),
- des moyens de mesure (15) de dimensions caractéristiques *(CD)* de l'ensemble de motifs de calibrage ($M_{CF}$,$D_{CF}$) après impression et des moyens de stockage de ces dimensions caractéristiques *(CD)* en mémoire (16),
- un processeur (12) ayant accès à la mémoire (16) et programmé pour fournir une estimation de la fonction d'étalement du point (PSF) caractérisant des électrons diffusés lors de l'impression à partir des dimensions caractéristiques *(CD)* mesurées,
- des moyens d'estimation (24) des motifs ($M'_{PF}$,$D'_{PF}$) à imprimer par convolution de la fonction d'étalement du point (PSF) fournie avec une valeur initiale ($M_{PF}$,$D_{PF}$) de ces motifs à imprimer,

**caractérisé en ce que**, chaque motif de calibrage ($M_C[i]$) destiné à être imprimé dans la résine comportant une zone centrale (26) exposée au faisceau d'électrons et une pluralité de zones concentriques à symétrie de révolution disposées autour de cette zone centrale (26) :

- les moyens de mesure (15) sont des moyens de mesure des dimensions caractéristiques *(CD)* des zones centrales (26) des motifs après impression, et
- le processeur (12) est programmé pour calculer l'estimation de la fonction d'étalement du point (PSF) en tant que somme d'une première portion de fonction d'étalement du point ($PSF_{BE}$) caractérisant des électrons rétrodiffusés par le substrat et d'une seconde portion de fonction d'étalement du point ($PSF_{FE}$) caractérisant des électrons diffusés dans la résine, et par inversion d'une modélisation analytique de l'effet, sur lesdites dimensions caractéristiques *(CD)*, de l'application de la première portion de fonction d'étalement du point (PSF) à l'ensemble de motifs de calibrage ($M_{CF}$,$D_{CF}$).

## Patentansprüche

1. Verfahren zur Bewertung von Druckmotiven ($M'_{PF}$, $D'_{PF}$) auf einer Platte oder auf einer Maske durch Elektronenstrahllithografie, umfassend die folgenden Schritte:

   - Drucken (100) durch Elektronenstrahllithografie in einem Harz, das auf einem Substrat angeordnet ist, einer Einheit von Kalibrierungsmotiven ($M_{CF}$, $D_{CF}$),
   - Messen (120) von charakteristischen Abmessungen (CD) der Einheit von Kalibrierungsmotiven ($M_{CF}$, $D_{CF}$)nach dem Drucken und Registrieren dieser charakteristischen Abmessungen (CD) im Speicher,
   - Liefern, durch einen Prozessor, der einen Zugriff auf den Speicher (16) aufweist, einer Schätzung (140) der Punktspreizfunktion (PSF), die beim Druck diffundierte Elektronen auf der Grundlage der gemessenen charakteristischen Abmessungen (CD) charakterisiert,
   - Schätzen (160) der Druckmotive ($M'_{PF}$, $D'_{PF}$) durch Konvolution der Punktspreizfunktion (PSF), geliefert mit einem Anfangswert ($M_{PF}$, $D_{PF}$) dieser Druckmotive,

   **dadurch gekennzeichnet, dass**:

   - jedes Kalibrierungsmotiv ($M_C[i]$), gedruckt in das Harz, einen zentralen Bereich (26) umfasst, der dem Elektronenstrahl ausgesetzt ist, und eine Vielzahl von konzentrischen Bereichen mit Rotationssymmetrie, die um diesen zentralen Bereich (26) angeordnet sind,
   - die charakteristischen Abmessungen (CD), gemessen nach dem Druck, charakteristische Abmessungen (CD) der zentralen Bereiche 26 der Motive sind, und
   - die Schätzung der Punktspreizfunktion (PSF) als Summe eines ersten Abschnitts der Punktspreizfunktion ($PSF_{BE}$), die durch das Substrat rückgestreute Elektronen charakterisiert, und eines zweiten Abschnitts der Punktspreizfunktion ($PSF_{FE}$), die im Harz diffundierte Elektronen charakterisiert, berechnet wird, und eine Umkehrung einer analytischen Modellisierung der Wirkung auf die charakteristischen Abmessungen (CD) der Anwendung des ersten Abschnitts der Punktspreizfunktion ($PSF_{BE}$) auf die Einheit der Kalibrierungsmotive ($M_{CF}$, $D_{CF}$) umfasst.

2. Verfahren zur Bewertung von Druckmotiven ($M'_{PF}$, $D'_{PF}$) nach Anspruch 1, wobei der Anwendung des ersten Abschnitts der Punktspreizfunktion ($PSF_{BE}$) auf die Einheit der Kalibrierungsmotive ($M_{CF}$, $D_{CF}$) analytisch durch das Produkt einer Matrix, die die Einheit von Kalibrierungsmotiven modelliert, mit einem Vektor modelliert wird, der den ersten Abschnitt der Punktspreizfunktion ($PSF_{BE}$) modelliert, wobei die Umkehrung der analytischen Modellierung durch eine Umkehrung der Matrix durchgeführt wird, die die Einheit von Kalibrierungsmotiven modelliert.

3. Verfahren zur Bewertung von Druckmotiven ($M'_{PF}$, $D'_{PF}$) nach Anspruch 2, wobei die Matrix, die die Einheit von Kalibrierungsmotiven ($M_{CF}$, $D_{CF}$) modelliert, eine quadratische Matrix der Ordnung n ist, die eine Einheit von n Motiven mit n konzentrischen Bereichen modelliert, wobei jede Linie der Matrix einem der Kalibrierungsmotive ($M_c[i]$) entspricht und jede Säule der Matrix einem dieser konzentrischen Bereiche ($A_c[k]$) entspricht.

4. Verfahren zur Bewertung von Druckmotiven ($M'_{PF}$, $D'_{PF}$) nach Anspruch 3, wobei die Matrix, die die Einheit der Kalibrierungsmotive ($M_{CF}$, $D_{CF}$) modelliert, auf der Grundlage einer Hadamard-Matrix ausgedrückt wird.

5. Verfahren zur Bewertung von Druckmotiven ($M'_{PF}$, $D'_{PF}$) nach Anspruch 4, wobei der erste Abschnitt der Punktspreizfunktion die die durch das Substrat rückgestreuten Elektronen, bezeichnet als $PSF_{BE}$, charakterisiert, durch den Folgenden Ausdruck definiert wird:

$$PSF_{BE} \propto \left( \frac{2}{n}H - \begin{bmatrix} 1 & 0 & \cdots & 0 \\ 0 & 0 & \cdots & 0 \\ \vdots & \vdots & & \vdots \\ 0 & 0 & \cdots & 0 \end{bmatrix} \right) \left( \begin{bmatrix} \frac{CD[1]}{S[1]} \\ \vdots \\ \frac{CD[n]}{S[n]} \end{bmatrix} - cd_0 \begin{bmatrix} 1 \\ \vdots \\ 1 \end{bmatrix} \right),$$

wobei das Symbol "$\propto$" eine Proportionalitätsbeziehung bezeichnet, H die Hadamard-Matrix ist, auf deren Grundalge die Einheit von Kalibrierungsmotiven ($M_{CF}$, $D_{CF}$) modellisiert wird, $\begin{bmatrix} \frac{CD[1]}{S[1]} \\ \vdots \\ \frac{CD[n]}{S[n]} \end{bmatrix}$ ein Vektor ist, umfassend die Einheit {CD[1], ... , CD[n]} der gemessenen charakteristischen Abmessungen, gewichtet durch die Einheit {S[1],...S[n]} der jeweiligen Oberflächen der konzentrischen Bereiche mit Rotationssymmetrie, und $cd_0$ eine charakteristische Konstante einer gemeinsamen Abmessung des zentralen Bereichs (26) jedes Kalibrierungsmotivs ($M_C[i]$) ist, wenn dieser zentrale Bereich (26) auf isolierte Weise dem Elektronenstrahl bei Abwesenheit von konzentrischen Bereichen mit Rotationssymmetrie um diesen zentralen Bereich (26) ausgesetzt ist.

6. Verfahren zur Bewertung von Druckmotiven ($M'_{PF}$, $D'_{PF}$) nach einem der Ansprüche 1 bis 5, wobei der zweite Abschnitt der Punktspreizfunktion ($PSF_{FE}$) auf der Grundlage einer Funktion vom Typ Gaußsche Funktion modelliert ist, wobei die Parameter dieser Gaußschen Funktion durch Simulation auf einer Vielzahl von Kalibrierungsmotiven bestimmt sind.

7. Verfahren zur Bewertung von Druckmotiven ($M'_{PF}$, $D'_{PF}$) nach einem der Ansprüche 1 bis 6, wobei die konzentrischen Bereiche ($A_c[k]$) mit Rotationssymmetrie der Kalibrierungsmotive die gleiche Oberfläche aufweisen.

8. Verfahren zur Bewertung von Druckmotiven ($M'_{PF}$, $D'_{PF}$) nach Anspruch 5 und 7, wobei der erste Abschnitt der Punktspreizfunktion ($PSF_{BE}$), der die durch das Substrat rückgestreuten Elektronen charakterisiert, durch den folgenden Ausdruck definiert wird:

$$PSF_{BE} \propto \left( \frac{2}{n}H - \begin{bmatrix} 1 & 0 & \cdots & 0 \\ 0 & 0 & \cdots & 0 \\ \vdots & \vdots & & \vdots \\ 0 & 0 & \cdots & 0 \end{bmatrix} \right) \left( \begin{bmatrix} CD[1] \\ \vdots \\ CD[n] \end{bmatrix} - cd_0 \begin{bmatrix} 1 \\ \vdots \\ 1 \end{bmatrix} \right).$$

9. Verfahren zur Bewertung von Druckmotiven ($M'_{PF}$, $D'_{PF}$) nach einem der Ansprüche 1 bis 8, wobei der zentrale Bereich (26) jedes Kalibrierungsmotivs ($M_c[i]$) einen der konzentrischen Bereiche mit Rotationssymmetrie umfasst, wobei dieser dann in das Zentrum des Motivs gestellt wird.

10. Vorrichtung zum Drucken (10) von Motiven ($M'_{PF}$, $D'_{PF}$) auf einer Platte oder einer Maske durch Elektronenstrahllithografie, umfassend:

- Mittel zum Drucken (14) durch Elektronenstrahllithografie in einem Harz, das auf einem Substrat angeordnet ist, einer Einheit von Kalibrierungsmotiven ($M_{CF}$, $D_{CF}$),
- Mittel zum Messen (15) von charakteristischen Abmessungen (CD) der Einheit von Kalibrierungsmotiven ($M_{CF}$, $D_{CF}$)nach dem Drucken und Mittel zum Ablegen dieser charakteristischen Abmessungen (CD) im Speicher (16),
- einen Prozessor (12), der einen Zugriff auf den Speicher (16) und das Programm aufweist, um eine Schätzung der Punktspreizfunktion (PSF) zu liefern, die Elektronen, diffundiert beim Druck, auf der Grundlage der gemessenen charakteristischen Abmessungen (CD) charakterisiert,
- Mittel zum Schätzen (24) der Druckmotive ($M'_{PF}$, $D'_{PF}$) durch Konvolution der Punktspreizfunktion (PSF), geliefert mit einem Anfangswert ($M_{PF}$, $D_{PF}$) dieser Druckmotive,

**dadurch gekennzeichnet, dass**, wobei jedes Kalibrierungsmotiv ($M_c$[i]), das ausgelegt ist, um in das Harz gedruckt zu werden, einen zentralen Bereich (26), der dem Elektronenstrahl ausgesetzt ist, und eine Vielzahl von konzentrischen Bereichen mit Rotationssymmetrie umfasst, die um diesen zentralen Bereich (26) angeordnet sind:

- die Mittel zum Messen (15) Mittel zum Messen der charakteristischen Abmessungen (CD) der zentralen Bereiche (26) der Motive nach dem Druck sind, und
- der Prozessor (12) programmiert ist, um die Schätzung der Punktspreizfunktion (PSF) als Summe eines ersten Abschnitts der Punktspreizfunktion ($PSF_{BE}$), die durch das Substrat rückgestreute Elektronen charakterisiert, und eines zweiten Abschnitts der Punktspreizfunktion ($PSF_{FE}$), die im Harz diffundierte Elektronen charakterisiert, und durch Umkehrung einer analytischen Modellierung der Wirkung auf die charakteristischen Abmessungen (CD) der Anwendung des ersten Abschnitts der Punktspreizfunktion (PSF) auf die Einheit von Kalibrierungsmotiven ($M_{CF}$, $D_{CF}$) zu berechnen.

## Claims

1. Method for estimating patterns ($M'_{PF}$,$D'_{PF}$) to be printed on a plate or mask by means of electron-beam lithography, comprising the following steps:

    - printing (100) by means of electron-beam lithography, in a resin arranged on a substrate, a set of calibration patterns ($M_{CF}$,$D_{CF}$),
    - measuring (120) characteristic dimensions (CD) of the set of calibration patterns ($M_{CF}$,$D_{CF}$) after printing and saving these characteristic dimensions (CD) to memory,
    - supplying, by means of a processor having access to the memory (16), an estimation (140) of the point spread function (PSF) characterising electrons scattered during printing based on the characteristic dimensions (CD) measured,
    - estimating (160) the patterns ($M'_{PF}$,$D'_{PF}$) to be printed by convoluting the point spread function (PSF) supplied with an initial value ($M_{PF}$,$D_{PF}$) of these patterns to be printed,

    **characterised in that**:

    - each calibration pattern ($M_C$[i]) printed in the resin includes a central zone (26) exposed to the electron beam and a plurality of concentric zones with rotational symmetry arranged about this central zone (26),
    - the characteristic dimensions (CD) measured after printing are characteristic dimensions (CD) of the central zones (26) of the patterns, and
    - the estimation of the point spread function (PSF) is calculated as the sum of a first point spread function portion ($PSF_{BE}$) characterising electrons back-scattered by the substrate and a second point spread function portion ($PSF_{FE}$) characterising electrons scattered in the resin, and comprises an inversion of analytical modelling of the effect, on said characteristic dimensions (CD), of applying the first point spread function portion ($PSF_{BE}$) to the set of calibration patterns ($M_{CF}$,$D_{CF}$).

2. Method for estimating patterns ($M'_{PF}$,$D'_{PF}$) to be printed according to claim 1, wherein the application of the first point spread function portion ($PSF_{BE}$) to the set of calibration patterns ($M_{CF}$,$D_{CF}$) is modelled analytically by the product of a matrix modelling the set of calibration patterns with a vector modelling the first point spread function portion ($PSF_{BE}$), the analytical modelling being inverted by inverting the matrix modelling the set of calibration patterns.

3. The method for estimating patterns ($M'_{PF}$,$D'_{PF}$) to be printed as claimed in claim 2, wherein the matrix modelling the set of calibration patterns ($M_{CF}$,$D_{CF}$) is a square matrix of order n that models a set of n patterns with n concentric zones, each row of the matrix corresponding to one of the calibration patterns ($M_C$[$i$]) and each column of the matrix corresponding to one of these concentric zones ($A_C$[$k$]).

4. The method for estimating patterns ($M'_{PF}$,$D'_{PF}$) to be printed as claimed in claim 3, wherein the matrix modelling the set of calibration patterns ($M_{CF}$,$D_{CF}$) is expressed using a Hadamard matrix.

5. The method for estimating patterns ($M'_{PF}$,$D'_{PF}$) to be printed as claimed in claim 4, wherein the first point spread function portion characterising the electrons back-scattered by the substrate, annotated $PSF_{BE}$, is defined by the following expression:

$$PSF_{BE} \propto \left( \frac{2}{n} H - \begin{bmatrix} 1 & 0 & \cdots & 0 \\ 0 & 0 & \cdots & 0 \\ \vdots & \vdots & & \vdots \\ 0 & 0 & \dots & 0 \end{bmatrix} \right) \left( \begin{bmatrix} \frac{CD[1]}{S[1]} \\ \vdots \\ \frac{CD[n]}{S[n]} \end{bmatrix} - cd_0 \begin{bmatrix} 1 \\ \vdots \\ 1 \end{bmatrix} \right),$$

where the symbol "$\propto$" denotes a proportional relationship, $H$ is the Hadamard matrix based on which the set of calibration patterns ($M_{CF}$,$D_{CF}$) is modelled, $\begin{bmatrix} \frac{CD[1]}{S[1]} \\ \vdots \\ \frac{CD[n]}{S[n]} \end{bmatrix}$ is a vector including the set {$CD$[1],...,$CD$[$n$]} of the characteristic dimensions measured, weighted by the set {$S$[1],...$S$[$n$]} of the respective areas of the concentric zones with rotational symmetry, and $cd_0$ is a characteristic constant of a common dimension of the central zone (26) of each calibration pattern ($M_C$[$i$]) when this central zone (26) is exposed in isolation to the electron beam in the absence of concentric zones with rotational symmetry about this central zone (26).

6. Method for estimating patterns ($M'_{PF}$,$D'_{PF}$) to be printed according to any of claims 1 to 5, wherein the second point spread function portion ($PSF_{FE}$) is modelled using a Gaussian function, the parameters of this Gaussian function being determined by simulation on a plurality of calibration patterns.

7. Method for estimating patterns ($M'_{PF}$,$D'_{PF}$) to be printed according to any of claims 1 to 6, wherein the concentric zones ($A_C$[$k$]) with rotational symmetry of the calibration patterns all have the same area.

8. Method for estimating patterns ($M'_{PF}$,$D'_{PF}$) to be printed according to claims 5 and 7, wherein the first point spread function portion ($PSF_{BE}$) characterising the electrons back-scattered by the substrate is defined by the following expression:

$$PSF_{BE} \propto \left( \frac{2}{n} H - \begin{bmatrix} 1 & 0 & \cdots & 0 \\ 0 & 0 & \cdots & 0 \\ \vdots & \vdots & & \vdots \\ 0 & 0 & \dots & 0 \end{bmatrix} \right) \left( \begin{bmatrix} CD[1] \\ \vdots \\ CD[n] \end{bmatrix} - cd_0 \begin{bmatrix} 1 \\ \vdots \\ 1 \end{bmatrix} \right).$$

9. Method for estimating patterns ($M'_{PF}$,$D'_{PF}$) to be printed according to any of claims 1 to 8, wherein the central zone (26) of each calibration pattern ($M_C$[$i$]) includes one of the concentric zones with rotational symmetry, positioned at the centre of said pattern.

10. Device (10) for printing patterns ($M'_{PF}$,$D'_{PF}$) on a plate or mask by means of electron-beam lithography, comprising:

   - means for printing (14) by means of electron-beam lithography, in a resin arranged on a substrate, a set of calibration patterns ($M_{CF}$,$D_{CF}$),
   - means for measuring (15) characteristic dimensions *(CD)* of the set of calibration patterns ($M_{CF}$,$D_{CF}$) after printing and means for storing these characteristic dimensions *(CD)* in memory (16),
   - a processor (12) having access to the memory (16) and programmed to supply an estimation of the point spread function (PSF) characterising electrons scattered during printing based on the characteristic dimensions *(CD)* measured,
- means for estimating (24) the patterns ($M'_{PF}, D'_{PF}$) to be printed by convoluting the point spread function (PSF) supplied with an initial value ($M_{PF}, D_{PF}$) of these patterns to be printed,

**characterised in that**, each calibration pattern ($M_C[i]$) to be printed in the resin comprising a central zone (26) exposed to the electron beam and a plurality of concentric zones with rotational symmetry arranged about this central zone (26):

- the measuring means (15) are means for measuring the characteristic dimensions (*CD*) of the central zones (26) of the patterns after printing, and
- the processor (12) is programmed to calculate the estimation of the point spread function (PSF) as the sum of a first point spread function portion ($PSF_{BE}$) characterising electrons back-scattered by the substrate and a second point spread function portion ($PSF_{FE}$) characterising electrons scattered in the resin, and by inverting analytical modelling of the effect, on said characteristic dimensions (*CD*), of applying the first point spread function portion (PSF) to the set of calibration patterns ($M_{CF}, D_{CF}$).

## Figure 1

## Figure 2

$M_c[1]$

$M_c[i]$

$M_c[n]$

26

$R_c[j]$

$R_c[j-1]$

$R_c[0]$

$R_c[1]$

$A_c[n]$

$A_c[k]$

$A_c[1]$

## Figure 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• DE 102010035047 A1

**Littérature non-brevet citée dans la description**

• **C. PIERRAT et al.** Mask data correction methodology in the context of model-base fracturing and advanced mask models. *Proceedings SPIE of Optical Microlithography,* 01 Mars 2011, vol. 7973